(19) Europäisches Patentamt
European Patent Office
Office européen des brevets

(11) EP 0 365 216 B2

(12) # NEW EUROPEAN PATENT SPECIFICATION

(45) Date of publication and mention
of the opposition decision:
**04.03.1998 Bulletin 1998/10**

(45) Mention of the grant of the patent:
**02.03.1994 Bulletin 1994/09**

(21) Application number: **89310471.1**

(22) Date of filing: **12.10.1989**

(51) Int Cl.6: **H01F 38/28**, G01R 35/02

(54) **Current sensor**

Stromsensor

Capteur de courant

(84) Designated Contracting States:
**CH DE ES FR GB LI**

(30) Priority: **18.10.1988 US 259234**

(43) Date of publication of application:
**25.04.1990 Bulletin 1990/17**

(73) Proprietor: **GENERAL ELECTRIC COMPANY
Schenectady, NY 12345 (US)**

(72) Inventor: **Bullock, Donald Frank
New Hampshire 03878 (US)**

(74) Representative: **Szary, Anne Catherine, Dr. et al
London Patent Operation,
GE International, Inc.,
Essex House,
12-13 Essex Street
London WC2R 3AA (GB)**

(56) References cited:
**DE-A- 3 401 594          GB-A- 2 199 149**

## Description

BACKGROUND OF THE INVENTION

1. Field of the Invention

The present invention relates to the general field of apparatus for sensing power line voltage and current components of alternating current electric energy, and more particularly to a current sensor.

2. Description of the Prior Art

Many electrical and electronic devices such as, for example, induction and electronic type watthour meters for metering electric power and energy usage, require means for sensing line current components flowing in a conductor, and producing an output signal which is accurately proportional, over a large range of magnitudes, to the line current. Induction type watthour metering devices for alternating current electrical energy measurement have been provided by producers for years, and have been used almost exclusively for measuring energy consumption by separate electrical energy users. Typically, watthour meters are used for indicating consumption in kilowatt hours. Induction type watthour meters typically have voltage and current coils and a rotating disc driven by fluxes from the two coils.

The current sensing circuit of a conventional induction watthour meter senses the current to be measured in a very direct manner. This sensing is done by wrapping the line current carrying conductor around an iron core to form a current coil to create a magnetic flux in the core which is used, in conjunction with flux from the voltage coil, to rotate the above mentioned disc at a rate proportional to electrical energy consumption. Current coil designs have been made using as many as 640 ampere turns around the core and which are capable of carrying up to 320 amperes.

Generally, if the magnitude of the line current to be measured is in excess of the above mentioned 320 amperes, or alternatively if the line conductor is at some high voltage potential with respect to ground, it is common practice, and frequently required, to interpose a current transformer between the watthour meter and the line conductor or current carrying circuit being metered. Such current transformers are usually rated at a nominal current in the secondary winding of 5 amperes, however, in many instances up to 20 amperes of secondary current may be used without exceeding the thermal rating of the transformer. A meter which is used to serve the above requirement is commonly referred to as a "transformer rated" watthour meter and typically has a maximum current coil rating of 20 amperes.

Large currents and voltages of the above type are suitable for induction type watthour meters. However, such large currents and voltages cannot be used in the design of a fully electronic watthour meter which uses electronic or integrated circuits for measurement and which are designed to operate at small signal levels many magnitudes below the line currents and voltages. The voltage and current inputs to the types of integrated circuits referred to are typically less than 5 volts or 5 milliamperes. Therefore, it is generally required that the sensors providing voltage and current responsive analog signals to the measuring circuits have large transformation ratios. In the case of current sensors, their output signals must be linear over a wide range in the magnitudes of the line current supplied to the sensors.

At a typical power utility customer location in the USA, sixty Hertz AC electric power is delivered at substantially constant line voltages in the range of 120-480 volts defining the line voltage components of the electric energy quantity to be measured.

On the other hand, line current which defines the current component of the electric energy to be measured, varies considerably. Typically, this variation is in a desired linear measurement range from one-half ampere to two hundred amperes or in a current range of approximately one to four hundred. Accordingly, conventional voltage transformer arrangements often can provide practical voltage sensing devices. However, current transformers receiving the aforementioned wide input variations and producing the required low level signal outputs often require structural arrangements which contribute to a substantial size and consequent increase in cost. It is well known by designers of such current transformers that the ampere turns of the primary and of the secondary must be equal. In addition, since maximum primary current levels may reach two hundred or more amperes, the primary and secondary winding sizes become large in order to produce the low level output signals required by the electronic measuring circuits.

In view of the foregoing, it can be seen that a need exists for a current sensing apparatus for scaling a large range of currents (eg. 20 to 200 amperes or more) to a suitable voltage and current level (eg. 1-5 volts or 1-5 milliamperes) for input to the above measuring circuits. Such scaling necessitates a large scaling ratio of 100,000:1 or more. In addition, if adequate metering accuracy is to be achieved, the magnitude and the phase angle of an output signal from the sensing apparatus must be very accurate with respect to the magnitude and phase of the line current being applied to the apparatus. Furthermore, the sensing apparatus must be physically small enough to fit within the physical design constraints, or envelope restrictions, of a conventional induction type watthour meter in order to comply with industry standards and to permit direct interchange of an electronic meter in place of an induction meter.

In addition to the foregoing needs, the sensing apparatus must provide isolation between its output signal point and its point of connection to the line current conductor, which may be operating at high current levels and at voltage levels of 480 volts rms or above. Such isolation also dictates that high voltage transients on the line current conductor be suppressed to prevent such transients from getting through the sensing apparatus and affecting the output signal therefrom.

Another problem which arises in current sensors which use current coils or transformers is saturation of the magnetic core caused by substantially any d.c. component superimposed on the waveform of the a.c. current flowing in the line conductor. It is well known by meter designers that a small d.c. component may be present on the line conductor as a result of incidental half wave rectification caused by various electrical apparatus connected to the line conductor. Persons intent on committing meter fraud have also been found to deliberately insert much larger d.c. components on the line conductor to significantly affect the metering accuracy of the current sensor. As such, a need also exists for a current sensor design which cannot be compromised by the presence of any d.c. component on the line conductor.

Current sensors are also known to generate an external magnetic field, and to also be affected by incident magnetic fields from other sources (including adjacent current sensors such as are employed in polyphase watthour meters). Thus, a further need exists for a current sensor design which generates only a mimimum external magnetic field and one which is sensibly unaffected by incident magnetic fields from other sources. Such a current sensor is highly desireable in a watthour meter where multiple current sensors are operated in close proximity.

Many prior art current sensor and transducer designs are known using various techniques, attempting to fulfill and solve the above needs and problems such as disclosed in U.S. patents; 4,182,982; 4,492,919; 4,496,932; 4,513,273; 4,616,174; and 4,749,940.

In attempts to solve the above mentioned problems and needs, the prior art contains several approaches for dividing a load current into two current paths to produce a sample current or voltage proportional to the load current.

Typical current divider techniques are disclosed in U.S. Pat. Nos. 4,182,982 and 4,492,919, wherein a current in a line conductor is split, or divided, into a main shunt path and a parallel auxiliary path. The auxiliary path contains a much smaller cross section than does the main shunt path and current through the divider path combination divides in substantially the ratio of the cross sections. A toroidal magnetic core with a winding of many turns is disposed about the auxiliary path. The auxiliary path thus forms a one-turn primary and the many turns about the toroidal core form a secondary winding. A current through the secondary is proportional to the current in the primary divided by the number of turns in the secondary. The techniques disclosed in these patents have several disadvantages. They use copper and thus suffer from reduced accuracy due to the substantial thermal coefficient of resistance of copper which may cause the resistance to change as much as 30 percent over the environmental temperature range to which watthour meters are exposed. In addition, it is difficult to obtain a sufficient current division to give the many orders of magnitude reduction (scaling) in output current or voltage compared to load current. Finally, these techniques are subject to output signal errors resulting from incidental magnetic fluxes surrounding the current divider and coil combination.

A further technique, disclosed in U.S. Patent No. 4,496,932, employs two slits in a substantially flat and longitudinal conductor to accommodate a measurement conductor which is inserted between a pair of shunt conductors connected in parallel with the measurement conductor. The measurement conductor is deflected, first in one direction, and then in the other, to provide an opening or space for the passage of a one turn loop of magnetic core material between the shunt conductors and the measurement conductor. In one embodiment, the shunts and the measurement conductor are folded into a U-shape to align holes in each leg of the U. The one-turn of the loop of magnetic material is then passed through the aligned holes for receiving a sample of current produced by the presence of the slits and the measurement conductor when current is passed through the shunt conductors and the measurement conductor. A secondary winding of many turns on the core loop serves to provide an output signal. This device suffers from the presence of strong magnetic fields in its vicinity which are capable of saturating the core and thus introducing errors in the output signal or cancelling the output. In addition, no provision is provided for cancelling the effects of non-uniform magnetic fields originating external to the measurement device, as are routinely experienced in watthour meters.

In addition to the foregoing set out disadvantages, prior art current sensors, and their attendant current dividers, of the type disclosed in the above patents have been found to suffer from two other principal disadvantages; namely (1) non linearity, and (2) phase shift between the input current and the output current or voltage from the sensor. The causes of items (1) and (2) are explained as follows:

(1) <u>Non Linearity</u>

The non linearity arises from variations in the resistance of various sections of the current divider which thereby affect the ratio of the two resistances forming the divider. Since the dividers have been designed to carry large currents in the order of hundreds of amperes, the examples noted in the above described patents have been constructed in copper to minimize self-heating due to $I^2R$ losses. Copper has a very high temperature coefficient of resistance, being about 0.4% per 1°C temperature change. It has therefore been necessary to adopt elaborate construction methods in an effort to achieve an isothermal condition for the whole body of the current divider.

In spite of these efforts the $I^2R$ losses, ambient temperature changes and solar heating inevitably create a heat flow in the divider which create small temperature differences between the various parts of the divider and as a consequence measurement errors occur.

(2) Phase Shift

The phase error arises from the magnetic coupling that exists between the parallel conductors in circuits that typically form a current divider. The shunt circuit that carries the majority of the current has an -associated magnetic field surrounding it, giving rise to self-inductance in the shunt circuit. This magnetic field also links with the parallel circuit that carries the measurement current, giving rise to mutual inductance between the two circuits. These inductances cause the divider to change from a simple resistance divider to a complex impedance divider with associated phase shifts dependent on the inductances. The complex geometry of the divider and its parallel conductor construction, together with the complex magnetic field distribution, prohibit any possibility of computing or predicting the above mentioned inductances and consequently the design of these current dividers has been largely an empirical process.

In view of the foregoing, it can be seen that a further need exists for a current sensor and current divider structure which lends itself to a calculable design approach rather than using an empirical approach.

GB-A-2199149 discloses a current sensor which comprises a current divider having a first resistor for carrying the major part of the current in parallel with a second resistor for carrying the minor part of the current. A current transformer may be coupled to the second resistor. The two resistors may have a variety of forms. In one form they are coaxial. The current divider (or shunt) of GB-2199149 is comprised largely of materials having very small temperature coefficients of resistance in the order of 20 parts per million per one degree centigrade. This is less than the temperature coefficient of copper by a factor of about 200. These materials also have bulk resistivities from about 25 to 80 times higher than copper. This application discloses design approaches and techniques using these materials in current sensors without any increase in the $I^2R$ losses in the sensor when compared to the current coil of the type used in an induction type watthour meter. For a teaching of these design approaches and the characteristics of those materials attention is invited to GB-A-2199149.

## SUMMARY OF THE INVENTION

In accordance with the present invention, there is provided a coaxial current sensor for providing an output signal proportional to current supplied thereto, comprising:

(a) a coaxial current divider for dividing current supplied thereto, including,

(i) a first conductor having an aperture extending therethrough between opposite ends thereof, possessing a resistance of a value $R_1$,

(ii) a second conductor coaxially disposed in the aperture of said first conductor, said second conductor being connected at opposite ends thereof to corresponding opposite ends of said first conductor, and possessing a resistance of a value $R_2$, whereby an input current, $I_{in}$, supplied to one end of said first and second conductors, divides into currents $I_1$ and $I_2$ flowing in said first and second conductors, respectively, and wherein the current $I_2$ flowing in said second conductor is given by:

$$I_2 = \frac{I_{in}}{K}$$

where

$$K = \left\{ \frac{R_2}{R_1} + 1 \right\};$$

and

(b) an output coaxially disposed about said second conductor and inductively coupled thereto and including a current comparator, for sensing the current 12 flowing in said second conductor and an amplifier connected to said comparator, said output means providing an output signal having a magnitude proportional to the magnitude of the current $I_{in}$ supplied to said current sensor and a substantially cylindrical third conductor, having a cylindrical aperture extending therethrough between first and second ends thereof, and coaxially disposed around said first conductor, said third conductor being connected at the second end thereof to each of the second ends of said first and second conductors, said third conductor generating a third magnetic field therearound in response to a current flowing between the first and second ends thereof, said third conductor including an output at the first end thereof, for exit of the current $I_{in}$, the currents $I_1$, $I_2$ and $I_{in}$ flowing through said first, second and third conductors, and producing, respectively the first, second and third magnetic fields in a predetermined interacting relationship, such that when the currents $I_1$ and $I_2$ flow from the first ends to the second ends of each of said first and second conductors, the current $I_{in} = I_1 + I_2$, flows from the second end to the first end of said third conductor, whereby beyond the outer surface of said third conductor, the sum of the first, second and third magnetic fields is substantially zero.

In a preferred embodiment, the current divider is constructed largely from conductive materials having very low temperature coefficients of resistance to minimize variation of the current sensor ratio with temperature, while the coaxial design of the current divider minimizes the phase error between the input current to the sensor and the scaled output signal from the current comparator.

In presently preferred embodiments, the one of the pair of current carrying elements, which is coupled to the current comparator, has a greater resistance than the resistance of the other current carrying element to thereby establish the magnitude of a first stage of scaling. Also, the current comparator may be a compensated current transformer having first and second secondary windings wound on a magnetic core, and the one of the pair of current carrying elements serves as a primary winding for the current transformer.

The amplifier, responsive to an output of the first secondary winding, may be employed to provide a control or compensating signal or current, to the second secondary winding to produce a flux in the core of the transformer to thereby reduce the flux in the core toward zero by balancing the ampere turns resulting from the current flowing in the primary winding and thus provide a second scaled output from the second secondary winding which is proportional to the AC current flowing through the current divider.

A better understanding of the present invention will become apparent upon consideration of the following detailed, illustrative, description. when read in conjunction with the drawings.

BRIEF DESCRIPTION OF THE DRAWING

Fig. 1 is a simplified electrical schematic of a current sensor in accordance with the invention and which is useful in understanding the operation thereof.

Fig. 2 is an isometric view of a first embodiment of a current sensor in accordance with the principles of the invention and which illustrates current connections adapting the sensor for use in an electronic watthour meter.

Fig. 3 is a sectioned view of the current sensor of Fig. 2.

Fig. 4 is an isometric view of another embodiment of the current sensor of the present invention.

Fig. 5 is a sectioned view of still another embodiment of the current sensor of the present invention.

Fig. 6a is an isometric view of a current divider in accordance with the principles of the invention.

Fig. 6b is an elevation drawing of the current divider of Fig. 6a and is useful in understanding the operation and design principles of the invention.

Fig. 6c is an equivalent circuit of the current sensor and is useful in understanding the operating and design principles of the invention.

Fig. 7 is a sectioned view similar to Fig. 3. but showing details of a structure and method of adjusting the ratio of a current divider of the present invention.

Fig. 8a is a schematic diagram of a current comparator and circuit useful in understanding the principles of the invention.

Fig. 8b is a schematic diagram of a current comparator with a d.c. stabilization circuit further useful in understanding the principles of the invention.

Fig. 8c is a schematic diagram of a current comparator with a different d.c. stabilization circuit.

Fig. 9a is a schematic diagram of a current comparator with a switched d.c. stabilization circuit according to the present invention.

Fig. 9b is a diagram of a control circuit suitable for controlling the switches in the circuit of Fig. 9a.

Fig 9c is a representation of the waveforms at various places in the circuit of Fig 9a.

DETAILED DESCRIPTION OF THE INVENTION

Prior to proceeding with a detailed description of illustrative embodiments of the invention, and to better appreciate the contribution to the art of current sensors, it is first believed advantageous to provide a basic operational description of, and the various design considerations to be taken into account in designing, current sensors embodying the present invention.

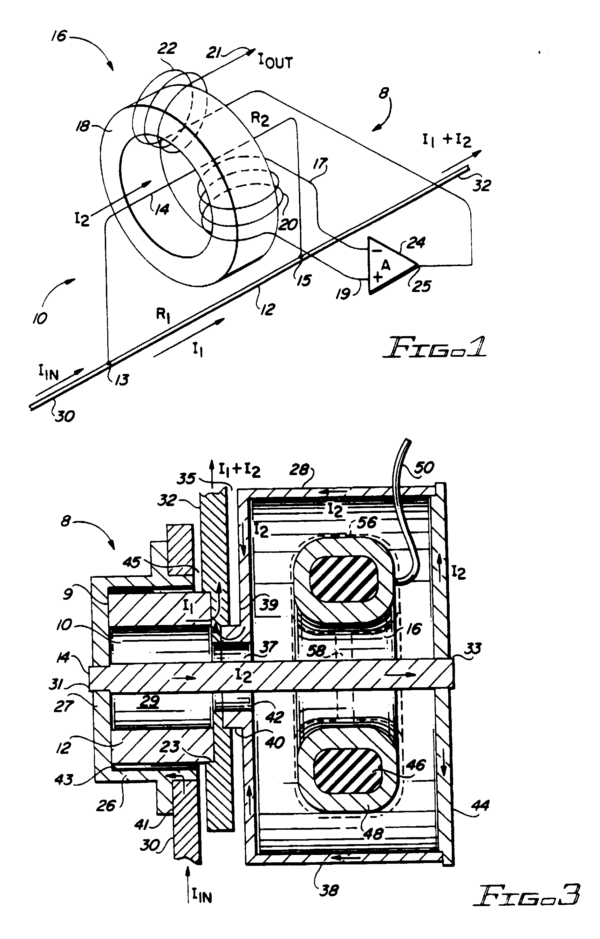

Now in context of the above, reference is first made to Fig. 1 which schematically illustrates a current sensor 8. The sensor 8 is comprised of a current divider, shown generally at 10, which includes a first current carrying element, shown as a shunt resistor 12 having a value $R_1$, and a second current-carrying element, shown as a measuring resistor 14 having a value $R_2$. As shown in Fig. 1, resistors 12 and 14 are connected in parallel at 13 and 15.

The current sensor 8 is designed to be connected in series with a current source (not shown) whereby an input current ($I_{in}$) in a conductor 30 flows through the sensor, via Resistors 12 and 14, and out of the Sensor in a Conductor 32 as total current $I_1 + I_2$.

The current, $I_{in}$, to be measured divides into a current $I_1$, in Shunt Resistor 12 and a current, $I_2$, in Measuring Resistor 14. The current 12, in Measuring Resistor 14 provides a first stage of scaling of the input current, $I_{in}$, and that current is given by:

$$I_2 = \frac{I_{in}}{K}$$

where

$$K = \left[ \frac{R_2}{R_1} + 1 \right] \qquad (1)$$

A Current Comparator, shown generally at 16, provides a second stage of scaling of the input current, $I_{in}$, by sensing the current $I_2$ flowing in Resistor 14 and providing a fully scaled output current or signal, $I_{out}$, having a magnitude proportional to the input current, $I_{in}$, but many magnitudes lower than $I_{in}$.

The Current Comparator 16 includes a Core 18 of magnetic material and First and Second Secondary Windings 20 and 22. Windings 20 and 22 each consist of a large number of turns of fine gage wire evenly distributed around the Core 18. It should be noted that Core 18 encircles Resistor 14, whereby Resistor 14 serves as a single turn primary winding for the Current Comparator 16.

The operating principles of the Current Comparator 16 are relatively straight forward and are well known in the art. It is well known that an alternating magnetic flux field surrounds any current-carrying conductor when an alternating current is passed through the conductor. In the Comparator 16 an alternating magnetic flux from Resistor 14 is induced in the Core 18. Secondary Winding 20 on Core 18 is used to sense the presence of this alternating flux in the core. This sensing results in a voltage being induced in the Winding 20 to provide an input signal, via Conductors 17 and 19, to negative (-) and positive (+) input terminals of a high gain differential Amplifier 24.

An Output Terminal 25 of Amplifier 24 is connected at 11 to one end of compensation or feedback Winding 22. The output signal from Amplifier 24 causes a current to flow in Winding 22 as an output signal, Iout, of the Comparator 16 at an output terminal 21. The direction of current flow through Winding 22 is such as to induce a compensating flux from Winding 22 into Core 18 to reduce the alternating flux in the core toward zero. The comparator and Amplifier arrangement operates, dynamically, to keep the alternating magnetic flux in Core 18 at a very low value approaching zero. As a result, the magnetizing ampere turns resulting from the measured or sensed current, $I_2$, in the single turn primary winding (formed by Resistor 14) of the Transformer 18 are balanced by the magnetizing ampere turns resulting from the current Iout flowing in the N-Turn Secondary Winding 22. Since the transformer ampere turns are equal, or balanced, then;

$$N \times Iout = I2 \times 1 \qquad\qquad (2)$$

$$Iout = \frac{I2}{N} \qquad\qquad (2a)$$

Substituting from Equation (1) yields:

$$Iout = \frac{Iin}{K \times N} \qquad\qquad (3)$$

The output signal, Iout, of the Current Sensor is, thus shown, to be a scaled version of the input alternating current,

$I_{in}$, where the final scaling factor is the product of two independent scale factors determined by a ratio of resistances (K) and a number of turns N in the output of Secondary Winding 22. Thus, it can be seen that a designer is able to select the independent scale factors to best satisfy the limitations of the Current Sensor while meeting the requirement for overall scale factor.

To develop an appreciation and understanding of the complexities and difficulties in developing a highly accurate current sensor as contemplated by the present invention, the following several practical considerations, understandings, findings and limitations, have been considered and at least some of which have lead to the preferred embodiments:

(1) Current Sensor Size

For the Current Sensor 8 to fit within the small physical constraints of an electronic watthour meter, and meet industrial installation and meter inter-change requirements, the sensor must be constructed of materials which lend themselves to making a small package that will fit within the above constraints.

(2) Current Divider Resistance

The Current Divider must be capable of carrying input or load current, $I_{in}$ without excessive heating or power loss. In the previously described prior art patents, these requirements led to the use of copper conductors for the parallel resistors which make up the divider.

Unfortunately, copper has a large temperature coefficient of resistance. Even a temperature difference of a fraction of 1°C between the parallel resistors of a divider will result in an unacceptable in the ratio factor K in equation (1). Such temperature difference can easily result from resistive heating, solar radiation and other influences. While copper may be used where accuracy is unimportant, it does not lend itself to current divider structures requiring high accuracy.

As previously mentioned, certain metal alloys have been developed specifically to have low temperature coefficient of resistance, typicallly of the order of 20 parts per million per degree centigrade. These materials are sold under trademarks such as Advance, Karma, Cuprothal 294, Nikrothal LX and Copel. All these alloys, in addition to low temperature coefficient, have high resistivity and are expensive. It has been found that these materials are ideally suited for use in small current sensors of the type contemplated by the present invention. However, if these materials are to be used in the current divider, it is necessary to use a large cross section to carry the current and a small length in order to keep the power dissipation small and the material usage to a minimum. Since the resistance alloy has to be joined to copper terminal conductors (or other conductive materials) care should be taken in designing these joints to ensure that no significant amount of copper conductor (or other material) is re-introduced into the divider current paths which will degrade the low temperature coefficient of the alloy.

(3) Current Divider Inductance

Any current carrying conductor (including Resistors 12 and 14) has associated with it a magnetic field. The interaction of the currents and magnetic fields result in self and mutual inductances which change the simple resistors of Fig. 1 into more complex impedances when the Current Sensor is used to measure A.C. currents. It is desirable to be able to calculate and control these inductances when designing the current divider ratner than using an empirical approach.

(4) D.C. Current Component

Any d.c. component in the load current, $I_{in}$, will also be present in current 12 in Measuring Resistor 14, reduced by the divider ratio K as in equation (1). This current must not be great enough to saturate the Magnetic Core 18 of the Current Comparator 16.

It has been found that, by using a ferrite material and suitable path length (ie. the mean or effective circumference) for Magnetic Core 18, a d.c. component of about 2 amperes can be sustained in $I_2$ flowing in Resistor 14 without seriously degrading the permeability of Magnetic Core 18. The d.c. component of $I_{in}$ can thus be about "2K" amperes without significant loss of measuring accuracy.

(5) Amplifier Stability

The Current Comparator 16 as shown in Fig. 1 operates with Amplifier 24 in a closed loop feed back mode as far as A.C. currents are concerned. This is because such currents will be coupled from the Amplifier's output back to its inputs via the mutual inductance between Windings 20 and 22 on Magnetic Core 18.

The Amplifier 24 has a small d.c. offset voltage present at its input terminals which, in the circuit as shown, would be amplified by the very large open loop gain of the Amplifier and result in complete saturation of its output. Therefore, as will subsequently be described, it is necessary to modify this simple circuit to provide d.c. feedback and stable operation.

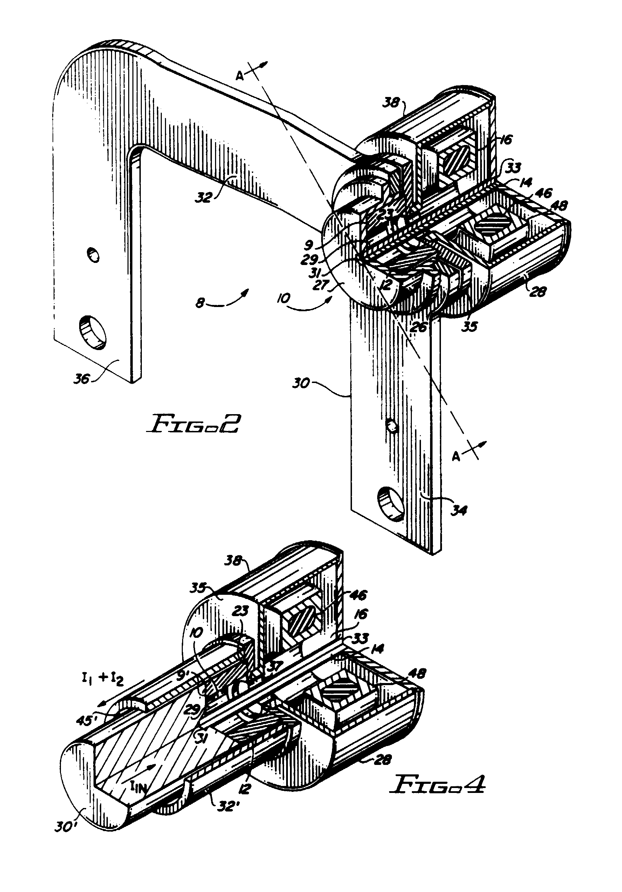

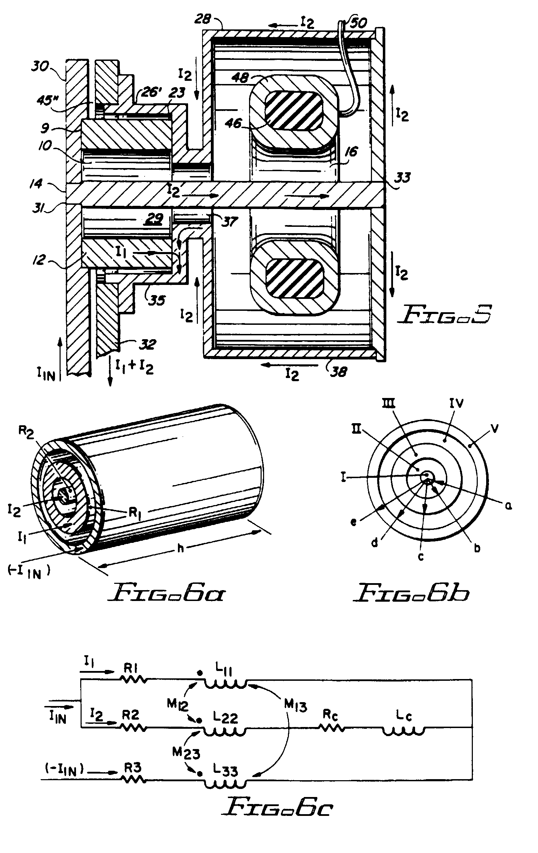

Reference is now made to Figs. 2 and 3 which show embodiments of the invention, wherein the Current Sensor 8 is constructed for use in an electronic watthour meter having a conventional meter base which is adapted to plug the meter into a conventional meter socket. The meter base and socket are not shown in the figures, however, it is understood that two Current Conductors 30 and 32, shown as blades 34 and 36, (in Fig. 2) normally protrude from the meter base and are plugged into the meter socket, to connect the Sensor 8 in series with a line conductor carrying the current to be sensed.

The Current Divider 10 of Sensor 8 is constructed of a cylindrical Conductive Housing, shown generally at 35, comprising two cylindrical Cup Shaped Conductive Members 26 and 28 which are joined together to form the Housing 35. Conductor 30 may form an integral part of Member 26 and Conductor 32 may form an integral part of Member 28. Preferably, the Conductive Housing 35, including Members 26 and 28 and Conductors 30 and 32, are of copper construction. However, other suitable conductive materials, such as aluminum, may be used. Further, while the embodiments are shown to be of a cylindrical construction and shape, it is understood that rectangular or other suitable shapes may be constructed.

The Shunt Resistor 12 is of a cylindrical construction and has an Aperture 29 extending lengthwise therethrough. It should be noted that Resistor 12 is of a larger cross section than Resistor 14 and thus is of a much lower resistance than Resistor 14. Resistor 12 is mounted within the Member 26 and is electrically isolated therefrom, except at its point of circumferential attachment of a first end at 9 to a Face or Bottom 27 of the Cup-Shaped Member 26. The other end of Resistor 12 is similarly attached at its other end at 23 to the open end of Member 28.

The Measuring Resistor 14 is shown as an elongated cylindrical rod disposed within the Aperture 29 of Resistor 12 and the hollow portion of Member 28. Member 28 has an Aperture 37 in its open end for receiving Resistor 14. Resistor 14 is electrically bonded, at opposite ends thereof at connections 31 and 33, to the Bottom 27 of Member 26 and to a Face or Bottom 44 of Member 28. Except for these points of connection, Resistor 14 is electrically isolated from the rest of the Current Divider 10.

Reference is now made specifically to Fig. 3, which is a cross-section view of the Sensor 8 taken along plane A-A in Fig. 2. Fig. 3 more clearly shows the connection or bonding details of the various parts of the Sensor. Member 28, at its open end, has a Neck 40 which contains the Aperture 37. The Conductor 32 has a Clearance Hole 42 through which the Resistor 14 passes. As can be seen, the Conductor 32 is attached on opposite faces thereof at 39 and 23 to the Member 28 and the Shunt Resistor 12, thus, bonding the Shunt Resistor 12, the Measurement Resistor 14 and the Conductive Cup-Shaped Member 28 into a current divider of unitary construction.

The construction of the Member 26 and its bonded Conductor 30 is also best shown in Fig. 3. The Conductor 30 is bonded at the circumference of Member 26 as shown by the connection made at a Shoulder 41 on Member 26.

The Current Comparator 16 is shown mounted within the Cup-Shaped Member 28 and is communicatively coupled to Resistor 14 to provide an output Signal Iout (Fig. 1) proportional to the input Current, $I_{in}$. Comparator 16 is a transformer comprised of a toroidal Magnetic Core 46 and is disposed around Resistor 14. Resistor 14 serves as a single turn primary winding for the transformer. Toroidal Secondary Windings 48 (Winding 20 and 22 of Fig. 1) are wound on Core 46. Terminations (input and output connections) from the Windings 48 are brought out through a hole in the Member 28 as shown at 50 in Fig. 3 for connection to an external amplifier such as Amplifier 24 in Fig. 1.

Having described the above interrelationships of the various elements and component parts of illustrative embodiments of the invention, it is significant to now point out the many advantages of those interrelationships which contribute to the embodiments' novel mechanical, electrical and functional characteristics.

It should be noted that all of the current carrying components of the Current Sensor 8 are preferably of a coaxial construction. As can be seen in Fig. 3, the Cup-Shaped Member 26 is circumferentially coaxially disposed around Resistor 12 by an Inner Wall 43 thereof which extends over a portion of Resistor 14 to a point 45 adjacent Conductor 32.

The above coaxial relationship is maintained throughout the Sensor 8, by the coaxial relationship of the Measurement Resistor 14 and Member 28, which are mounted coaxially with respect to each other as well as being coaxial with Member 26 and Resistor 12. Further, it will be noted that the transformer Core 46 of Comparator 16 is also coaxial with all of the other component parts of the Sensor by being coaxially disposed around Resistor 14.

The designer has several design choices available to achieve a desired output current, $I_{out}$, for a given input current, $I_{in}$. First the number of turns in the secondary windings of Comparator 16 can be readily changed. Second, the cross section areas of Shunt Resistor 12, Measuring Resistor 14, or both can be readily varied simply by changing their diameter. Third, the resistance alloys used for making Shunt Resistor 12 and Measuring Resistor 14 can selected from the several low temperature coefficient materials previously described. Different alloys can be chosen for each of the resistors. Fourth, the lengths of Shunt Resistor 12 and Measuring Resistor 14 can be varied.

A basic understanding of the flow of current through the Sensor 8 and the operation of the Comparator 16 is relatively straight forward.

Let it be assumed that Conductors 30 and 32 of Fig. 3 are connected in series with a power source providing a current to be sensed or measured. The current to be measured, $I_{in}$, enters the Current Sensor 8 at Conductor 30 and Conductive Member 26 as shown by the arrows in Fig. 3.

The current, $I_{in}$ divides at the Connections 9 and 31 at the Face 27 of Member 26 to thus flow as currents $I_1$ and $I_2$ through Resistors 12 and 14 respectively. The current, $I_2$, to be measured flows through R14 and the Member 28, via an outer wall or shell 38 thereof. The current $I_2$, in the shell 38 flows into Conductor 32 at connection 39 where it is combined with the Current $I_1$ and thus combined as $I_1 + I_2$, exits at the output of Conductor 32. The output current

$I_1 + I_2$ is, of course, equal to input current $I_{in}$.

As previously mentioned, Resistor R14 has a magnetic field surrounding it when current is flowing therethrough. The Current Comparator 16 senses the flux from this magnetic field and generates an output signal proportional to $I_{in}$. This output signal was previously described as $I_{out}$ in connection with the previous description of Fig. 1. Reference is made to that previous description for a basic understanding of the operation of Comparator 16.

It is noteworthy to point out at this time that the coaxial construction of the various elements of the Sensor 8 contain attributes which provide an interaction between the various self inductances of those elements, and the complex mutual inductances therebetween, which results in a Current Sensor design substantially void of any magnetic field being generated external to the sensor resulting from the current flowing through the sensor. Conversely, incident magnetic fields from other sources (including the sensor's own current entry and exit Conductors 30 and 32 have negligible effect on the operation and accuracy of the Sensor. As a result, multiple current sensors can be operated in close proximity with very little interaction between the sensors - a distinct benefit in many applications, such as watthour meters where multiple sensors are frequently used. A more detailed description and analysis of the above attributes will later be given.

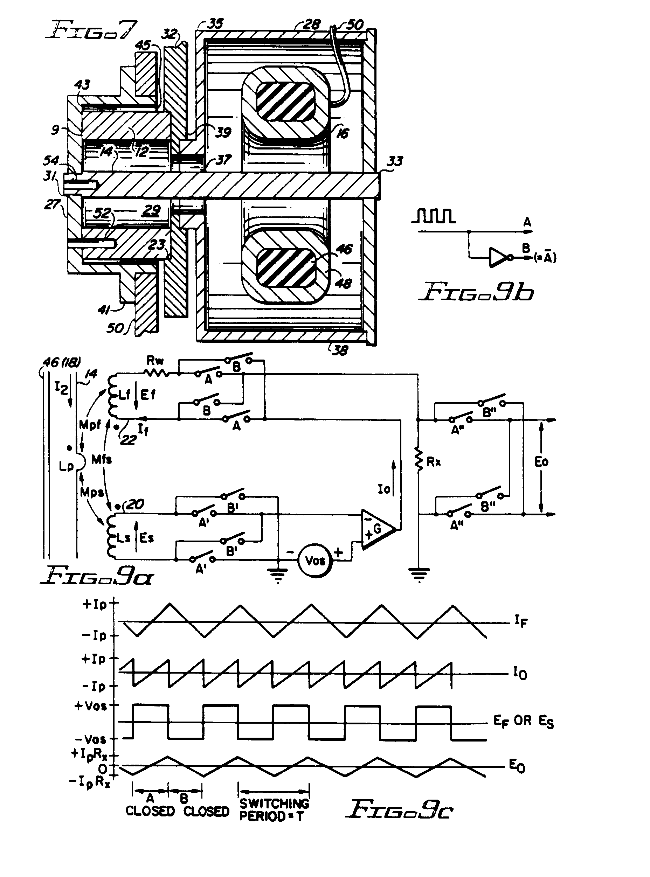

Reference is now made to Fig. 4 which shows another embodiment of the Current Sensor 8 which is substantially the same as the embodiment of Figs. 2 and 3. In this embodiment, however, the entry and exit Conductors 30 and 32 (shown as 30' and 32') are coaxial with the total Sensor. This embodiment has the advantage that Conductors 30' and 32' may be coaxially longitudinally extended outward from the Sensor as far as is required. Like numbers in Fig. 4 correspond to like numbers in Fig. 3.

It should be noted that the currents $I_{in}$ and $I_1 + I_2$ ($= I_{in}$) in Fig. 4 flow in opposite directions through adjacent parallel, coaxial paths. Such an arrangement has the advantage that the magnetic fields surrounding Conductors 30' and 32' are equal and opposite, to thus cancel each other out, with the attendant benefit that no external magnetic fields are generated, while simultaneously maintaining the Sensor substantially immune to the effects of incident magnetic fields in the vicinity of Conductors 30' and 32'.

It should be noted in Fig. 4 that the cup-shaped Member 26 is not required. In this embodiment the input current, $I_{in}$, is applied directly to Conductor 30' which is firmly bonded to Resistors 12 and 14 at 9' and 31' as shown. Further, it will be noted that Conductor 32' is an integral part of Member 28 and is firmly bonded to Resistors 12 and 14 at 23 and 33.

The operation of the Sensor of Fig. 4 is substantially as described for Fig. 3, and as such no further description is believed necessary.

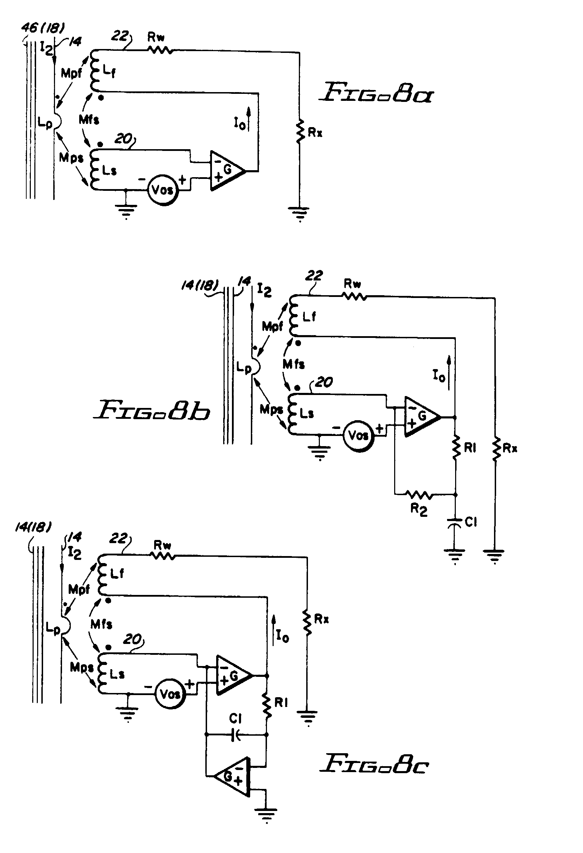

Fig. 5 shows still a further embodiment of the invention similar to Fig. 3 wherein the Current Divider 10 and Comparator are both on the same side (ie, the outward end of Resistor 12) of the entry and exit Conductors 30 and 32. It should also be noted that Conductors 30 and 32 are re-arranged to be adjacent similar to Conductors 30' and 32 of Fig. 4, whereby the magnetic fields caused by currents $I_{in}$ and $I_1 + I_2$ are substantially self cancelling.

In the embodiment of Fig. 5, the Cup-Shaped Member 26 forms an integral part of Member 28 as shown by the designation 26'. It will also be noted that the Conductor 30 serves as an end plate in place of the Bottom 27 of Member 26 of Fig. 3, and is joined to Resistors 12 and 14 to form the current dividing points for $I_{in}$.

The operation of the Fig. 5 embodiment is substantially as given for Fig. 1, 3 and 4, and no further explanation is believed necessary.

In furtherance of other details of the design and construction of embodiments of the invention, reference is now made back to Fig. 3

As previously pointed out, it can be seen that Measuring Resistor 14 is not the only resistive component of $R_2$. The Conductive Member 28, including its bottom cover or base 44 and cylindrical Shell 38, is in series with Measuring Resistor 14. Preferably, Member 28 is constructed of copper such that its resistance is less than 1% of the resistance of Resistor 14, thus making the effect in its change of resistance with temperature negligible.

It should also be noted that the Bottom 27 of Member 26 forms an equipotential surface with respect to Shunt Resistor 12 and Measuring Resistor 14. As such, within the inside diameter of Shunt Resistor 12, there is no current flow in Bottom 27 associated with the current $I_1$ in Resistor 12.

In a similar fashion, so long as Neck 40 of Member 28 has a diameter substantially equal to or less than the inside diameter of Shunt Resistor 12, then Conductor 32 is an equipotential surface with respect to Resistor 12 and Member 28.

Careful attention to the above connection and design principles permits Shunt Resistor 12 to be kept to a very low value of the order of 30-40 microohms with attendant low $I^2R$ losses, while still maintaining temperature independence. It should be noted, however, that the joints or bonds between Shunt Resistor 12 and Member 26 and Conductor 32 should have a very low resistance. As such, these bonds shall be made with great care by brazing, welding or other suitable processes.

In the foregoing description, all of the current carrying elements of the Sensor 8 have been specified as preferably copper, with the exception of Resistors 12 and 14. Other low resistance materials, such as aluminum, could be used, however, the low cost of copper and the difficulties associated with joining to aluminum make copper the preferred choice.

A detailed analysis and a teaching of the design principles of the embodiments of the invention will now be given.

Referring to Fig. 6, there is shown in Fig. 6a an isometric view of the Sensor 8 and Coaxial Current Divider 10. Fig. 6b is an elevation of the Current Divider, and in Fig. 6c there is shown an equivalent circuit of the Current Sensor showing the self and mutual inductances in the Sensor.

In Fig. 6a, there are shown the currents $I_{in}$, $I_1$, and $I_2$ corresponding to these same currents as previously described for Figs. 1-3. Also shown is a length "h", corresponding to the length of the Sensor or Coaxial Divider 10.

In Fig. 6b the radii of the various components of the Coaxial Current Divider are shown together with Roman numbers I through V, indicating five volumes associated with these radii and the length "h" of the Divider.

In Fig. 6c, a self inductance $L_{11}$ and Resistance $R_1$ are associated with the conductor carrying $I_1$, i.e. Shunt Resistor 12. Similarly self inductance $L_{22}$ and Resistance $R_2$ are associated with $I_2$ and Measuring Resistor 14 while self inductance $L_{33}$ and Resistance $R_3$ are associated with $I_{in}$ and Conductive Member 26. $M_{12}$, $M_{13}$ and $M_{23}$ are the mutual inductances between the conductors carrying $I_1$, $I_2$ and $I_{in}$. Self inductance $L_c$ and resistance $R_c$ are associated with that part of Measuring Resistor 14 that is outside the Coaxial Current Divider and include the Conductive Member 28 and the reflected impedance of Current Comparator 16 and its associated Amplifier 24 as seen by the single turn primary winding formed by Measuring Resistor 14.

Analysis of the circuit in Fig. 6c shows the current divider ratio to be;

$$\frac{I_2}{I_{in}} = \frac{1}{K} = \frac{(R_1)+j\omega(L_{11}-M_{12}-M_{13}+M_{23})}{(R_1+R_2+R_c)+j\omega(L_{11}-M_{12}+L_{22}-M_{12}+L_c)} \tag{4}$$

It should be observed that $L_{33}$ and $R_3$ do not appear in expression (4) and thus do not affect the divider ratio.

The resistances $R_1$ and $R_2$ are those associated with volumes I and III in Fig. 6c and are given by;

$$R_1 = \frac{\rho_1 h}{\pi(c^2-b^2)} \tag{5}$$

$$R_2 = \frac{\rho_2 h}{\pi a^2} \tag{6}$$

where $\rho_1, \rho_2$ are the resistivities of the materials of $R_1, R_2$.

To calculate the inductances it must first be noted that due to the coaxial construction, there is no magnetic field beyond the outside radius "e" of the outer conductor (ie, the outside radius of Sensor 8). This can be shown by using Amperes circuital law along a circular path just outside cylindrical Member 26.

$$\oint H.dl = I$$

Since no net current is enclosed and the system has circular symmetry, $H_\phi$, the tangential component, must equal zero.

Energy relationships can now be used to calculate the inductances. The energy stored in a magnetic field is;

$$W_H = \frac{1}{2} \int_{vol} B.H \, dV \tag{7}$$

Since there is no magnetic material in the system of Fig. 6 then, $B = \mu_0 H$ and;

$$W_H = \frac{\mu_0}{2} \int_{vol} H^2 dV \tag{8}$$

The energy stored in the magnetic field is also given by;

$$W_{H=\frac{1}{2}}LI^2 \tag{9}$$

From equations (8) and (9) we get;

$$L = \frac{\mu_0}{I^2}\int_{vol}H^2 dV \tag{10}$$

Equation (10) has to evaluated for the volumes I through V In Fig. 6b.
Consider a typical thin cylindrical shell coaxial with the system having a radius r, thickness dr and a volume dV;

$$dV = hx2\pi rdr \tag{11}$$

Substituting in equation (10) we get;

$$L = \frac{\mu_0 2\pi h}{I^2}\int_{r_1}^{r_2}H^2 rdr \tag{12}$$

We note that;

$$H = \frac{I'}{2\pi r} \tag{13}$$

Where I' is the current enclosed at the radius r

$$L = \frac{\mu_0 h}{2\pi (I)^2}\int_{r_1}^{r_2}(I')^2\frac{1}{r}dr \tag{14}$$

Similarly it can be shown that the mutual inductances are given by;

$$M = \frac{\mu_0 h}{2\pi I_1 I_2}\int_{r_1}^{r_2}(I_1')(I_2')\frac{1}{r}dr \tag{15}$$

where $I_1'$, and $I_2'$ are the currents in Resistances 12 and 14 enclosed at the radius r.
Expressions (14) and (15) can be evaluated for values of r between 0 (center of R2 axis) and "e", the outside diameter of the outer conductor (Member 26), in order to calculate $L_{11}$; $L_{22}$; $M_{12}$; $M_{13}$; $M_{23}$.

It is found that $M_{23} = M_{13}$, thus equation (4) becomes;

$$\frac{I_2}{I_{in}} = \frac{1}{K} = \frac{(R_1)+j\omega(L_{11}-M_{12})}{(R_1+R_2+R_C)+j\omega(L_{11}-M_{12}+L_{22}-M_{12}+L_C)} \tag{16}$$

It is also found that;

$$(L_{11}-M_{12}) = \frac{\mu_0 h}{2\pi}\left[\left(\frac{b^2}{c^2-b^2}\right)\ln\left(\frac{c}{b}\right) + \ln\left(\frac{c}{a}\right) - \frac{1}{4}\right] \tag{17}$$

$$(L_{22}-M_{12}) = \frac{\mu_0 h}{2\pi}\left[\left(\frac{b^2 c^2}{(c^2-b^2)^2}\right)\ln\left(\frac{c}{b}\right) - \frac{(c^2+b^2)}{4(c^2-b^2)}\right] \tag{18}$$

It will be noted that equations (5); (6); (17) and (18), which evaluate the separate terms of equation (16), each contain terms only in the dimensions a, b, c, and h (Fig. 6b). The divider ratio is therefore dependent only on the dimensions of Shunt Resistor 12 and Measuring Resistor 14, and is entirely independent of the dimensions of cylindrical Member 26.

It is found that the term $(L_{11}-M_{12})$ from equation (17) is always negative for practical values of a, b and c, while the term $(L_{22}-M_{12})$ from equation (18) is always positive and larger than $(L_{11}-M_{12})$. Therefore, from equation (16), it can be seen that $I_2$ will always lag $I_{in}$ by a small angle.

The above analysis has ignored the self and mutual inductances that result from the radial current flows in Bottom 27 and Conductor 32. These inductances are very small, however, and the close agreement between the results of the above analysis and measurements on actual models justify ignoring the end effects.

A design engineer now has all the information needed to design the Current Sensor 8 and Divider 16 and accurately predict its performance.

In most applications it is required that the Current Sensor has an accurate fixed ratio between the input current ($I_{in}$) and the output current or signal ($I_{out}$). The Current Comparator section of the disclosed sensor has an accurate ratio determined by the number of turns in the Secondary Windings. The Current Divider section described above, however, has a ratio dependent on the dimensions a,b,c,h and the resistivity of the materials in the Shunt Resistor 12 and Measuring Resistor 14.

The dimensions and resistivities all have manufacturing tolerances such that the nominal divider ratio in equation (16) may vary by about $\pm 5\%$ as manufactured and, thus, there may be a need for an adjustment process.

Fig. 7 shows a simple method of making such adjustments in the Sensor by drilling one or more holes 52 through Bottom 27 and into Shunt Resistor 12. A hole such as this has the effect of reducing the cross sectional area of Shunt Resistor 12 and thereby increasing its resistance $R_1$. In a typical design where b = .188" (4.77mm) and c = .312" (7.92mm), the effective area of Shunt Resistor 12 is equivalent to a solid cylinder .500" (12.7mm) diameter. Since the wall thickness of the cylinder is .125" (3.175mm), it is easy to drill in it a hole .050" (1.27mm) diameter, i.e. 10% of the equivalent diameter. This hole has an area equal to 1% of the cylinder and, if drilled right through the cylinder would increase the resistance $R_1$ by 1%. By drilling a shorter hole of appropriate depth, adjustment to within less than 0.1% of the desired value can be achieved. If more than 1% adjustment is required, larger holes or multiple holes can be used. This method of adjustment will of course only increase $R_1$ and thus increase $I_2$ in equation 16. If an adjustment in the opposite direction is required, it also is possible to drill a hole 54 in Measuring Resistor 14, however, since the radius "a" of this resistor is quite small, typically 0.04" (1.02mm) to 0.08" (2.03mm), it is more difficult to drill a hole and its effect on the ratio is much greater.

The preferred method of adjustment is to design the Sensor such that, the nominal ratio is sufficiently less than the desired ratio that all manufactured assemblies, even at maximum tolerance, have a ratio less than desired; thus permitting all adjustments to be made by drilling hole(s) 52 in Shunt Resistor 12. The adjustment can then be readily performed with automated measuring and drilling equipment.

Referring now to Fig. 8a there is shown the basic equivalent circuit of the Current Comparator 16. For a.c. signals it can be shown that the comparator ratio is;

$$\frac{I_0}{I_2} = \frac{1}{N} = \frac{-\omega(GM_{ps}+N_{pf})}{\omega(GNfs+Lf)-j(Rw+Rx)} \tag{19}$$

Since the sense and feed back windings 20 and 22 are toroidally wound on a high permeability toroid Core 18, there is virtually no leakage flux and if the sense and feedback windings have $N_s$ and $N_f$ turns, while the primary winding (Resistor 14) has one turn then;

$$
\begin{aligned}
M_{ps} &= KN_s \\
M_{pf} &= KN_f \\
M_{fs} &= KN_fN_s \\
L_f &= K(N_f)^2
\end{aligned}
\left.\vphantom{\begin{aligned}1\\2\\3\\4\end{aligned}}\right\} \tag{20}
$$

Where K is a constant dependent on the dimensions of toroid Core 18 and the permeability of the core material. Combining equations (19) and (20) we get;

$$\frac{I_0}{I_2} = \frac{1}{N} = \frac{-\omega K(GN_s+N_f)}{\omega K N_f(GN_s+N_f)-j(R_w+R_x)} \tag{21}$$

Since W, K, $N_f$ and G are large compared to $R_w$ (winding 22 resistance) and $R_x$ (load resistance), the last term in the denominator $j(R_w + R_x)$ has no effect on magnitude and negligible effect on the phase angle and can be ignored, hence;

$$\frac{I_0}{I_2} = \frac{1}{N} = -\frac{1}{N_f} \tag{22}$$

In the analysis above the amplifier input d.c. offset voltage, $V_{os}$, was ignored. This small input voltage, present in all amplifiers, has no feedback path from the amplifier output to the amplifier input, and consequently will be amplified by the large open loop gain, G, of the amplifier and will drive the output of the amplifier to saturation and prevent the amplifier from operating in a linear fashion. This problem can be overcome by the prior art solutions shown in Figs. 8b and 8c and disclosed in U.S. Patent Nos. 4,182,982 and 4,761,605. These patents are incorporated herein by reference for a detailed description of the operation of such circuits. A brief explanation of the circuits, however, will be given.

In the circuits of Figs. 8b and 8c, a d.c. feedback path is provided in the form of a low pass filter. If the Current Comparator is to operate with high accuracy, the low pass filter must have high attenuation at 50/60 Hz. power frequencies which results in a time constant for the $R_1$-$C_1$ circuit of several seconds.

For practical application of the current sensor to power circuit measurements, a long time constant is unacceptable, because the large transients found in these circuits may cause shock excitation of the amplifier and result in a large slowly decaying oscillation.

An improved circuit for this purpose is disclosed in the aforementioned U.S. Patent No. 4,761,605, which is assigned to the assignee of the present invention. The disclosures of that patent are incorporated herein by reference. Fig. 9a shows the circuit of that disclosure, and which differs from Fig. 8a only by the inclusion of a set of switches A and B. The switches, which may be suitable FET or CMOS semiconductor devices, are arranged so that when switches A are closed or "ON", switches B are open or "OFF"; and when switches A are open or "OFF", switches B are closed or "ON".

Fig. 9b shows a suitable control circuit which is responsive to a square wave input signal to provide control signals for switching switches A and B.

Fig. 9c shows the waveforms for the voltages and currents in the circuit of Fig. 9a. (Note that the waveforms are shown when $I_2 = 0$)

As described in Patent 4,761,605, the principle of the circuit is to convert a d.c. signal $I_0$ at the amplifier output to an a.c. signal $I_f$ at the feedback winding 22 by means of the reversing switches A and B. The a.c. signal $I_f$ is coupled from the feedback winding 22 to the sense winding 20 by the mutual inductance $M_{fs}$ and if $N_s = N_f$ then $E_s = E_f$. The a.c. signal $E_s$ from the sense winding 20 is synchronously rectified by the second set of reversing switches A' and B' and thus converted back to a d.c. voltage suitable to cancel the amplifier offset voltage $V_{os}$.

It will be seen that the triangular wave of the current $I_f$ in the feedback winding 22 ($L_f$) generates a square wave of voltage ($E_f$, $E_s$) in both the sense and feedback windings 20 and 22 ($L_s$ and $L_f$) according to the equation;

$$E_s = E_f = M_{fs}\left(\frac{2I_p}{0.5T}\right) = L_f\left(\frac{2I_p}{0.5T}\right) \tag{23}$$

The commutating effect of the switches reverses the negative half of the $E_s$ waveform, thereby creating a constant voltage $V_{os}$ at the inverting (-) input of the amplifier which cancels the inherent offset voltage of the amplifier. The $I_o$ current waveform will be superimposed on the normal $I_o$ current as an error signal. From equation (23);

$$I_{err(Pk\text{-}Pk)} = 2I_p = \frac{V_{os}T}{2L_f} \tag{24}$$

The error signal is proportional to $V_{os}$ and can be minimized by increasing the inductance of the feedback winding 22 ($L_f$) or increasing the switching frequency, thus decreasing the switching period T shown in Fig. 9c. If the switching frequency is in the order of a few hundred hertz and the inductance of the feedback winding 22 ($L_f$) is several henries, the error signal is less than 1 microamp peak to peak (ie., +Ip-(-Ip)) per millivolt of amplifier offset voltage.

In many a.c. power applications the Current Sensor is used to provide an input signal to a watt or watthour meter. In such applications, a multiplication process is used between the current signal and a voltage signal to generate an instantaneous watts signal. The voltage signal will normally contain only the fundamental power frequency and harmonics thereof. If the switching frequency of the amplifier stabilization circuit is chosen <u>not</u> to be a harmonic of the power frequency there will be no correlation with the voltage signal and the effect of the error signal will average to zero over a cycle of the power line frequency. See patent 4,761,605 for more information regarding this multiplication process.

In other applications, a higher switching frequency will reduce the error signal and also make it easier to attenuate the error signal by filtering if required.

The switches A and B, while accomplishing d.c. feedback, also invert the desired signal component in $I_o$ and a third set of switches A" and B" may be used to remove this signal inversion as shown in Fig. 9a.

An additional feature of the current comparator, not previously described, is an Electrostatic Shield shown at 56 in Fig. 3. It will be appreciated that all of the conductive metal parts of Current Divider 10 may be at the line voltage of the power system to which Current Divider 10 is connected in order to measure the line current. Current Comparator 16, on the other hand is connected to Amplifier 24, which is part of the electronic circuit of, for example, a watthour meter. Since the electronic circuit is very sensitive to electrical noise and extraneous signals, it is normal practice to connect this circuit to a ground reference. Therefore, a large AC voltage difference exists between Cup-Shaped Member 28 (being part of Current Divider 10) and Current Comparator 16.

A first outcome of this voltage difference is a requirement to provide an insulation structure between Cup-Shaped Member 28 and Current Comparator 16, capable of withstanding this voltage difference. Such an insulation structure may readily be provided in the form of a molded plastic housing around Current Comparator 16. The described structure has been omitted from the figures in the interests of clarity.

A second outcome of the voltage difference is the presence of capacitive coupling between Cup-Shaped Member 28 and Windings 48 of Current Comparator 16. Such capacitive coupling, particularly to Secondary Winding 22, may result in an undesired error signal at the input to Amplifier 24 where the input signal in normal operation is close to zero. To overcome this error signal problem, it is desirable to enclose Windings 48 within a conductive Electrostatic Shield 56 as shown in Fig. 3. Such a shield is well known in the art as a Faraday Shield may take many forms, such as a conductive or metallic coating on the inside surfaces of the previously mentioned molded plastic housing, or a separate thin metal enclosure for Current Comparator 16, located within the insulation structure.

The shield is required to be connected to the ground reference of the electronic circuit and may also enclose Winding Connections 11, 17, 19, and 21 between Current Comparator 16 and Amplifier 24 in the form of a shielded cable.

Electrostatic Shield 56 preferably should enclose Windings 48 to the greatest possible extent, but it is important that in so doing, a complete closed turn is not created around toroid Core 46, whereby current could flow within the shield and cause additional ampere turns around the core resulting in large errors in Current Comparator 16. To this end, a small Gap 58 may be left in Electrostatic Shield 56 to prevent formation of a closed turn. As an alternative solution, the edges of Electrostatic Shield 56 may be lapped one over the other, but insulated from one another, to prevent completion of a closed turn.

While several preferred embodiments of the invention have been described with some particularity herein, many variations and modifications will now become apparent to those skilled in the art. By way of example, while the coaxial current sensor is disclosed as being an assembly of cylindrically shaped components, the conductive Members 26 and 28, the Resistors 12 and 14 and the Current Comparator 16, need not be cylindrical, but may be of rectangular or other shapes which are interrelated and bonded together to perform multiple current scaling and provide a current sensor. These embodiments may lose some of the attributes of the preferred embodiments such as absence of external magnetic fields, immunity to incident magnetic fields and minimal phase error between the input current to the sensor and the output signal of the sensor but still provide adequate performance in many applications.

It is contemplated that the invention may have application to a current sensor where high accuracy is not a requirement. To that end, it is expressly contemplated that the alloys of Resistors 12 and 14, which are disclosed as resistive materials preferably having very low temperatures coefficient of resistance, be replaced by other conductive materials, such as cooper and aluminum, or resistance alloys having higher temperature coefficients of resistance.

While a coaxial design of the Current Sensor 8 is disclosed as that design which meets the overall objectives of a highly accurate current sensor, it is understood that such a design may not have to be totally coaxial. For example, it is contemplated that an operational current sensor may be constructed of at least some parts, which are not coaxially related, and which still provides the attendant advantages of Sensor 8 by an interrelationship of component parts which provides the required divisions of current and the interrelationships of the self and mutual inductances between the current carrying parts of the sensor to provide a scaled output signal, $I_{out}$, which is sufficiently accurate for at least some current measurement applications.

## Claims

1. A coaxial current sensor (8) for providing an output signal proportional to current supplied thereto, comprising:

   (a) a coaxial current divider (10) for dividing current supplied thereto, including,

      (i) a first conductor (12), having an aperture (29) extending therethrough between first and second opposite ends (23,9) thereof, possessing a resistance of a value R1;
      (ii) a second conductor (14) coaxially disposed in the aperture (29) of said first conductor (12), said second conductor (14) being connected at first and second opposite ends (33,31) thereof to opposite ends (23,9) of said first conductor (12), and possessing a resistance of a value $R_2$, whereby an input current, $I_{in}$, supplied to one end (9,31) of said first and second conductors (12,14), divides into currents $I_1$ and $I_2$ flowing in said first and second conductors (12,14) which generate first and second magnetic fields therearound, respectively, and wherein the current $I_2$ flowing in said second conductor (14) is given by:

$$I_2 = \frac{I_{in}}{K}$$

   where

$$K = \left\{ \frac{R_2}{R_1} + 1 \right\};$$

   and

   (b) an output (21) coaxially disposed about said second conductor (14) and inductively coupled thereto and including a current comparator (16), for sensing the current $I_2$ flowing in said second conductor (14) and an amplifier (24) connected to said comparator (16), said output (21) providing an output signal having a magnitude proportional to the magnitude of the current $I_{in}$ supplied to said current sensor (8); and characterized by:
   (c) a substantially cylindrical third conductor, (26,32') having a cylindrical aperture extending therethrough between first and second ends thereof, and coaxially disposed around said first conductor (12), said third conductor (26,32') being connected at the second end thereof to each of the second ends (9,31) of the said first and second conductors (12,14), said third conductor (26,32') generating a third magnetic field therearound in response to a current flowing between the first and second ends thereof, said third conductor (26,32') including an output at the first end thereof, for exit of the current $I_{in}$, the currents $I_1$, $I_2$ and $I_{in}$ flowing through said first, second and third conductors (12,14,26,32'), and producing, respectively the first, second and third magnetic fields in a predetermined interacting relationship, such that when the currents $I_1$ and $I_2$ flow from the first ends (23,33) to the second ends (9,31) of each of said first and second conductors (12,14), the current, $I_{in} = I_1 + I_2$, flows from the second end to the first end of said third conductor (26,32'), whereby beyond the outer surface of said third conductor (26,32'), the sum of the first, second and third magnetic fields is substantially zero.

2. The coaxial current sensor in accordance with claim 1, wherein said first (12) and second (14) conductors are of materials having very low temperature coefficients of resistance.

3. The coaxial current sensor in accordance with claim 2, wherein the resistance $R_1$ of said first conductor (12) is less than the resistance $R_2$ of said second conductor (14).

4. The coaxial current sensor in accordance with claim 3, wherein said first conductor (12) has a larger cross-section than the cross-section of said second conductor (14) to thereby establish the values of $R_1$ and $R_2$, respectively.

5. The coaxial current sensor in accordance with claim 1, wherein

said current comparator is a toroidal core transformer (18), having wound thereon first and second secondary windings (20, 22), coaxially disposed around said second conductor (14) whereby said second conductor serves as a primary winding for said toroidal core transformer.

6. The coaxial current sensor in accordance with claim 5, wherein

said amplifier (24) has a small offset voltage, and has an input (17, 19) connected to said first secondary winding (20) for sensing magnetic flux in the toroidal core and an output (25) connected to said second secondary winding for providing a compensating signal to said second secondary winding (22) to maintain the flux in the toroidal core at substantially zero, and a switching circuit connected between said amplifier and each of said first and second secondary windings, whereby the small offset voltage is converted to an A.C. signal, coupled through said first and second secondary windings, and rectified to compensate for the offset voltage at the input to said amplifier.

7. The coaxial current sensor in accordance with claim 6, wherein

said second secondary winding (22) includes an output terminal for providing the output signal from said output to a load.

8. The coaxial current sensor in accordance with claim 1, wherein

said first and second conductors (12, 14) and said output (21, 32) are substantially enclosed by first and second conductive members (26, 28), said first and second conductors, each being connected at opposite ends thereof to a corresponding one of said first and second conductive members to form said coaxial current divider, whereby the input current $I_{in}$, when supplied to one of said first and second conductive members, divides into the currents $I_1$ and $I_2$ flowing in said first and second conductors to thereby be combined, in the other one of said first and second conductive members, as $I_1 + I_2$ equal to $I_{in}$.

9. A current sensor according to claim 8, wherein said second conductive member (28) is a conductive, substantially cup-shaped, member bonded at its open end to an end of said first conductor (12) and having disposed, on the inside thereof, said second conductor (14), the latter being bonded, at the other end thereof, to said cup-shaped member; and

said current comparator is disposed inside said cup-shaped member.

10. A current sensor according to claim 8, wherein said first conductive member (26) is a conductive first housing having a closed end and an open end and including a first terminal (30) supplying input current thereto;

said first conductor (12) is disposed in said housing, and attached at one end thereof to the closed end of said housing, said first conductor (12) having an aperture extending therethrough in coaxial alignment with said first housing, and being isolated from said first housing except at its point of attachment thereto;

said second conductor (14) is coaxially disposed in the aperture of said first conductor and being in coaxial alignment with said first housing, said second conductor (14) being isolated from said first conductor (12) and having one end thereof attached to the closed end of said first housing and having a portion thereof, at its other end, extending beyond said first resistor;

said second conductive member (28) being a second housing, having a closed end and an open end, said second housing having disposed therein, from its open end, a portion of said second conductor (14), said second conductor being attached, at its other end, to the closed end of said second housing, and said second housing being attached, at its open end, to the other end of said first conductor, said second conductor being isolated from said second housing except at its point of attachment thereto, said second housing including a second terminal (32) for carrying current exiting from said current sensor; and said current comparator (16) being mounted inside said second housing, and inductively coupled to said second conductor.

11. The coaxial current divider in accordance with claim 1, further including an output (21) coaxially disposed around said second conductor (14), said output being inductively coupled to said second conductor (14), and responsive to the second magnetic field therearound, for sensing the current $I_2$ flowing in said second conductor (14) and generating a scaled output signal having a magnitude proportional to the magnitude of the current $I_{in}$ supplied to said coaxial current divider (10), and wherein the interacting relationship of the first, second and third magnetic fields further results in a reduction of the phase angle between $I_2$ and $I_{in}$, whereby said scaled output signal is substantially in phase with the current $I_{in}$.

**Patentansprüche**

1. Koaxialer Stromsensor (8) zur Lieferung eines Ausgangssignals proportional zu einem zugeführten Strom, enthaltend:

(a) einen koaxialen Stromteiler (10) zum Teilen von zugeführtem Strom, enthaltend:

(i) einen ersten Leiter (12) mit einer Öffnung (29), die sich zwischen seinen ersten und zweiten gegenüberliegenden Enden (23, 9) durch den Leiter erstreckt und einen Widerstand mit einem Wert $R_1$ besitzt,
(ii) einen zweiten Leiter (14), der in der Öffnung (29) des ersten Leiters (12) koaxial angeordnet ist und an seinen ersten und zweiten gegenüberliegenden Enden (33, 31) mit gegenüberliegenden Enden (23, 9) des ersten Leiters (12) verbunden ist und einen Widerstand mit einem Wert $R_2$ besitzt, wobei ein Eingangsstrom $I_{in}$, der dem einen Ende (9, 31) der ersten und zweiten Leiter (12, 14) zugeführt ist, in Ströme $I_1$ und $I_2$ geteilt wird, die in den ersten bzw. zweiten Leitern (12, 14) fließen, die erste bzw. zweite Magnetfelder um sie herum erzeugen, und wobei der Strom $I_2$, der in dem zweiten Leiter (14) fließt, gegeben ist durch:

$$I_2 = \frac{I_{in}}{K} ,$$

wobei

$$K = \left[ \frac{R_2}{R_1} + 1 \right]$$

und

(b) einen Ausgang (21), der koaxial um den zweiten Leiter (14) herum angeordnet ist und mit diesem induktiv gekoppelt ist und einen Stromkomparator (16) zum Abtasten des Stromes $I_2$, der in dem zweiten Leiter (14) fließt, und einen Verstärker (24) aufweist, der mit dem Komparator (16) verbunden ist, wobei der Ausgang (21) ein Ausgangssignal mit einer Größe liefert, die der Größe des dem Stromsensor (8) zugeführten Stroms $I_{in}$ proportional ist, und gekennzeichnet durch:

(c) einen im wesentlichen zylindrischen dritten Leiter (26, 32'), der eine zylindrische Öffnung aufweist, die sich zwischen seinen ersten und zweiten Enden durch ihn hindurch erstreckt, und koaxial um den ersten Leiter (12) herum angeordnet ist, wobei der dritte Leiter (26, 32') an seinem zweiten Ende mit den jeweiligen zweiten Enden (9, 31) der ersten und zweiten Leiter (12, 14) verbunden ist und ein drittes Magnetfeld um ihn herum erzeugt, wenn ein Strom zwischen seinen ersten und zweiten Enden fließt, wobei der dritte Leiter (26, 32') einen Ausgang an seinem ersten Ende aufweist für einen Austritt des Stroms $I_{in}$, wobei die Ströme $I_1$, $I_2$ und $I_{in}$ durch die ersten, zweiten und dritten Leiter (12, 14, 26, 32') fließen und auf entsprechende Weise die ersten, zweiten und dritten Magnetfelder in einer vorbestimmten Wechselwirkungsrelation erzeugen, so daß, wenn die Ströme $I_1$ und $I_2$ von den ersten Enden (23, 33) zu den zweiten Enden (9, 31) von jedem der ersten und zweiten Leiter (12, 14) fließen, der Strom $I_{in} = I_1 + I_2$ von dem zweiten Ende zu dem ersten Ende des dritten Leiters (26, 32') fließt, wodurch außerhalb der äußeren Oberfläche des dritten Leiters (26, 32') die Summe der ersten, zweiten und dritten Magnetfelder im wesentlichen null ist.

2. Koaxialer Stromsensor nach Anspruch 1, wobei der erste (12) und zweite (14) Leiter aus Materialien sind, die sehr kleine Temperaturkoeffizienten des Widerstandes aufweisen.

3. Koaxialer Stromsensor nach Anspruch 2, wobei der Widerstand $R_1$ des ersten Leiters (12) kleiner ist als der Widerstand $R_2$ des zweiten Leiters (14).

4. Koaxialer Stromsensor nach Anspruch 3, wobei der erste Leiter (12) einen größeren Querschnitt als den Querschnitt des zweiten Leiters (14) hat, um dadurch die Werte $R_1$ bzw. $R_2$ festzulegen.

5. Koaxialer Stromsensor nach Anspruch 1, wobei der Stromkomparator ein einen toroidförmigen Kern aufweisender Wandler (18) ist, auf den erste und zweite Sekundärwicklungen (20, 22) gewickelt sind, die koaxial um den zweiten Leiter (14) herum angeordnet sind, wobei der zweite Leiter als eine Primärwicklung für den einen toriodförmigen Kern aufweisenden Wandler dient.

6. Koaxialer Stromsensor nach Anspruch 5, wobei der Verstärker (24) eine kleine Offset-Spannung hat und einen Eingang (17, 19), der mit der ersten Sekundärwicklung (20) verbunden ist zum Abtasten des Magnetflusses in dem toroidförmigen Kern, und einen Ausgang (25) aufweist, der mit der zweiten Sekundärwicklung verbunden ist zum Liefern eines Kompensationssignals an die zweite Sekundärwicklung (22), um den Fluß in dem toriodförmigen Kern im wesentlichen auf Null zu halten, und wobei eine schaltende Schaltungsanordnung zwischen den Verstärker und jede der ersten und zweiten Sekundärwicklungen geschaltet ist, wodurch die kleine Offset-Spannung in ein Wechselspannungssignal umgewandelt wird, mit den ersten und zweiten Sekundärwicklungen in Verbindung steht und gleichgerichtet wird, um die Offset-Spannung an dem Eingang zum Verstärker zu kompensieren.

7. Koaxialer Stromsensor nach Anspruch 6, wobei die zweite Sekundärwicklung (22) einen Ausgangsanschluß aufweist zur Lieferung des Ausgangssignales von dem Ausgang zu einer Last.

8. Koaxialer Stromsensor nach Anspruch 1, wobei die ersten und zweiten Leiter (12, 14) und der Ausgang (21, 32) durch erste und zweite leitfähige Teile (26, 28) im wesentlichen umschlossen sind, wobei die ersten und zweiten Leiter jeweils an ihren gegenüberliegenden Enden mit einem entsprechenden der ersten und zweiten leitfähigen Teile verbunden sind, um den koaxialen Stromteiler zu bilden, wobei sich der Eingangsstrom $I_{in}$, wenn er einem der ersten und zweiten leitfähigen Teile zugeführt wird, in die Ströme $I_1$ und $I_2$ teilt, die in den ersten und zweiten Leitern fließen, um dadurch in dem anderen der ersten und zweiten leitfähigen Teile als $I_1 + I_2$ gleich $I_{in}$ zusammengefaßt zu werden.

9. Stromsensor nach Anspruch 8, wobei das zweite leitfähige Teil (28) ein leitfähiges, im wesentlichen becherförmiges Teil ist, das an seinem offenen Ende mit einem Ende des ersten Leiters (12) verbunden ist und an dessen Innenseite der zweite Leiter (14) angeordnet ist, wobei letzterer an seinem anderen Ende mit dem becherförmigen Teil verbunden ist, und der Stromkomparator an der Innenseite des becherförmigen Teils angeordnet ist.

10. Stromsensor nach Anspruch 8, wobei das erste leitfähige Teil (26) ein leitfähiges erstes Gehäuse ist, das ein geschlossenes Ende und ein offenes Ende und einen ersten Anschluß (30) aufweist zum Zuführen des Eingangsstroms,

der erste Leiter (12) in dem Gehäuse angeordnet und an seinem einen Ende an dem geschlossenen Ende des Gehäuses befestigt ist, wobei der erste Leiter (12) eine Öffnung aufweist, die sich in koaxialer Ausrichtung durch das erste Gehäuse erstreckt und von dem ersten Gehäuse isoliert ist, außer an seinem Befestigungspunkt an dem Gehäuse,

der zweite Leiter (14) koaxial in der Öffnung des ersten Leiters angeordnet und in koaxialer Ausrichtung mit dem ersten Gehäuse ist, wobei der zweite Leiter (14) von dem ersten Leiter (12) isoliert ist und sein eines Ende an dem geschlossenen Ende des ersten Gehäuses befestigt ist und an seinem anderen Ende einen Abschnitt aufweist, der sich über den ersten Widerstand hinaus erstreckt,

das zweite leitfähige Teil (28) ein zweites Gehäuse ist, das ein geschlossenes und ein offenes Ende aufweist, wobei in dem zweiten Gehäuse, von seinem offenen Ende, ein Abschnitt des zweiten Leiters (14) angeordnet ist, der zweite Leiter an seinem anderen Ende an dem geschlossenen Ende des zweiten Gehäuses befestigt ist, und das zweite Gehäuse an seinem offenen Ende an dem anderen Ende des ersten Leiters befestigt ist, der zweite Leiter von dem zweiten Gehäuse isoliert ist, außer an seinem Befestigungspunkt, das zweite Gehäuse einen zweiten Anschluß (32) aufweist zum Führen von Strom, der aus dem Stromsensor austritt, und der Stromkomparator (16) innerhalb des zweiten Gehäuses angebracht und induktiv mit dem zweiten Leiter gekoppelt ist.

11. Koaxialer Stromteiler nach Anspruch 1, wobei ferner koaxial um den zweiten Leiter (14) herum ein Ausgang (21) angeordnet ist, der mit dem zweiten Leiter (14) induktiv gekoppelt ist und auf das zweite Magnetfeld um ihn herum anspricht zum Abtasten des in dem zweiten Leiter (14) fließenden Stroms $I_2$ und zum Erzeugen eines skalierten Ausgangssignals mit einer Größe, die zu der Größe des dem koaxialen Stromteiler (10) zugeführten Stroms $I_{in}$ proportional ist, und wobei die Wechselwirkungsrelation der ersten, zweiten und dritten Magnetfelder ferner eine Verkleinerung des Phasenwinkels zwischen $I_2$ und $I_{in}$ zur Folge hat, wodurch das skalierte Ausgangssignal im wesentlichen gleichphasig mit dem Strom $I_{in}$ ist.

**Revendications**

1. Détecteur coaxial (8) de courant pour fournir un signal de sortie proportionnel au courant qui lui est fourni, comprenant :

(a) un diviseur coaxial (10) de courant pour diviser le courant qui lui est fourni, comprenant,

(i) un premier conducteur (12), comportant une ouverture (29) s'étendant d'un bout à l'autre entre les première et deuxième extrémités opposées (23, 9) de ce conducteur, lequel possède une résistance d'une valeur $R_1$,

(ii) un second conducteur (14) disposé coaxialement dans l'ouverture (29) du premier conducteur (12), le second conducteur (14) étant connecté, à ses première et seconde extrémités opposées, aux extrémités opposées (23, 9) du premier conducteur (12), et possédant une résistance d'une valeur $R_2$, grâce à quoi un courant d'entrée $I_{in}$ fourni à l'une des extrémités (9, 31) des premier et second conducteurs (12, 14) se divise en des courants $I_1$ et $I_2$ qui circulent dans lesdits premier et second conducteurs (12, 14) et qui génèrent autour de ces derniers des premier et second champs magnétiques, respectivement, le courant $I_2$ circulant dans le second conducteur (14), étant donné par :

$$I_2 = I_{in} / K$$

où

$$K = \{(R_2 / R_1) + 1\},$$

et

(b) un moyen de sortie (21) disposé coaxialement autour du second conducteur (14) et couplé par induction à ce dernier et comprenant un comparateur (16) de courant pour détecter le courant $I_2$ circulant dans le second conducteur (14) et un amplificateur (24) connecté audit comparateur (16), ledit moyen de sortie fournissant un signal de sortie ayant une amplitude proportionnelle à l'amplitude du courant $I_{in}$ fourni au détecteur de courant (8), caractérisé par

c) un troisième conducteur (26, 32') sensiblement cylindrique, comportant une ouverture cylindrique s'étendant d'une extrémité à l'autre entre les première et seconde extrémités de ce conducteur et disposé coaxialement autour du premier conducteur (12), ledit troisième conducteur (26, 32') étant connecté, au niveau de sa seconde extrémité, à chacune des secondes extrémités (9, 31) des premier et second conducteurs (12, 14), ledit troisième conducteur (26, 32') engendrant autour de lui-même un troisième champ magnétique en réponse à un courant circulant entre ses première et seconde extrémités, ledit troisième conducteur (26, 32') comprenant une sortie à sa première extrémité pour la sortie du courant $I_{in}$, les courants $I_1$, $I_2$ et $I_{in}$ circulant à travers les premier, second et troisième conducteurs (12, 14, 26, 32') et produisant, respectivement, les premier, second et troisième champs magnétiques dans une relation d'interaction prédéterminée, de telle sorte que lorsque les courants $I_1$ et $I_2$ circulent des premières extrémités (23, 33) vers les secondes extrémités (9, 31) de chacun des premier et second conducteurs (12, 14), le courant $I_{in} = I_1 + I_2$, circule de la seconde extrémité vers la première extrémité du troisième conducteur (26, 32'), grâce à quoi, au-delà de la surface extérieure du troisième conducteur (26, 32'), la somme des premier, second et troisième champs magnétiques est sensiblement nulle.

2. Détecteur coaxial de courant selon la revendication 1, dans lequel les premier (12) et second (14) conducteurs sont en des matériaux ayant de très faibles coefficients thermiques de résistance.

3. Détecteur coaxial de courant selon la revendication 2, dans lequel la résistance $R_1$ du premier conducteur (12) est inférieure à la résistance $R_2$ du second conducteur (14).

4. Détecteur coaxial de courant selon la revendication 3, dans lequel le premier conducteur (12) a une section transversale plus grande que la section transversale du second conducteur (14) de manière à établir ainsi les valeurs de $R_1$ et $R_2$, respectivement.

5. Détecteur coaxial de courant selon la revendication 1, dans lequel le comparateur de courant est un transformateur (18) à noyau torique sur lequel sont enroulés des premier et second enroulements secondaires (20, 22) disposés coaxialement autour du second conducteur (14), grâce à quoi le second conducteur sert d'enroulement primaire pour le transformateur à noyau torique.

6. Détecteur coaxial de courant selon la revendication 5, dans lequel l'amplificateur (24) présente une tension de décalage faible et comporte une entrée (17, 19) connectée au premier enroulement secondaire (20) pour détecter le flux magnétique dans le noyau torique et une sortie (25) connectée au second enroulement secondaire pour fournir un signal de compensation au second enroulement secondaire (22) afin de maintenir le flux dans le noyau torique sensiblement à une valeur nulle, et un circuit de commutation monté entre l'amplificateur et chacun des premier et second enroulements secondaires, grâce à quoi la faible tension de décalage est convertie en un signal de courant alternatif, couplé par l'intermédiaire des premier et second enroulements secondaires, et redressé de manière à compenser la tension de décalage à l'entrée de l'amplificateur.

7. Détecteur coaxial de courant selon la revendication 6, dans lequel le second enroulement secondaire (22) comprend une borne de sortie pour fournir à une charge le signal de sortie en provenance de ladite sortie.

8. Détecteur coaxial de courant selon la revendication 1, dans lequel les premier et second conducteurs (12, 14) et la sortie (21, 32) sont sensiblement enfermés par des premier et second éléments conducteurs (26, 28), lesdits premier et second conducteurs étant chacun connectés à leurs extrémités opposées à un élément correspondant parmi lesdits premier et second éléments conducteurs pour former les diviseurs coaxiaux de courant, grâce à quoi le courant d'entrée $I_{in}$, lorsqu'il est fourni à l'un desdits premier et second éléments conducteurs, se divise en donnant les courants $I_1$ et $I_2$, qui circulent dans lesdits premier et second conducteurs de manière à se combiner dans l'autre desdits premier et second éléments conducteurs, $I_1 + I_2$, étant égal à $I_{in}$.

9. Détecteur de courant selon la revendication 8, dans lequel le second élément conducteur (28) est un élément conducteur, sensiblement en forme de cuvette, relié à son extrémité ouverte à une extrémité du premier conducteur (12) et à l'intérieur duquel est disposé le second conducteur (14), ce dernier étant relié, à son autre extrémité, audit élément en forme de cuvette; et le comparateur de courant est disposé dans l'élément en forme de cuvette.

10. Détecteur de courant selon la revendication 8, dans lequel le premier élément conducteur (26) est un premier boîtier conducteur comportant une extrémité fermée et une extrémité ouverte et comprenant une première borne (30) qui fournit un courant d'entrée;

le premier conducteur (12) est disposé dans ledit boîtier et est fixé, à l'une de ses extrémités, à l'extrémité fermée de ce boîtier, le premier conducteur (12) comportant une ouverture s'étendant de façon traversante en alignement coaxial avec le premier boîtier et étant isolé de ce premier boîtier sauf à son point de fixation à ce dernier;

le second conducteur (14) est disposé coaxialement dans l'ouverture du premier conducteur et se trouve en alignement coaxial avec le premier boîtier, le second conducteur (14) étant isolé du premier conducteur (12) et ayant une de ses extrémités fixée à l'extrémité fermée du premier boîtier et ayant sa partie, située à son autre extrémité, s'étendant au-delà de ladite première résistance;

le second élément conducteur (28) étant un second boîtier ayant une extrémité fermée et une extrémité ouverte, une partie du second conducteur (14) étant disposée dans ledit second boîtier, depuis son extrémité ouverte, ledit second conducteur étant fixé, à son autre extrémité, à l'extrémité fermée du second boîtier, et le second boîtier étant fixé, à son extrémité ouverte, à l'autre extrémité du premier conducteur, le second conducteur étant isolé du second boîtier sauf à son point de fixation à ce dernier, le second boîtier comprenant une seconde borne (32) pour transporter le courant sortant dudit détecteur de courant; et le comparateur de courant (16) étant monté à l'intérieur du second boîtier et étant couplé par induction au second conducteur.

11. Diviseur coaxial de courant selon la revendication 11. comprenant, en outre, une sortie (21) disposée coaxialement autour du second conducteur (14), ladite sortie étant couplée par induction au second conducteur (14) et réagissant au second champ magnétique environnant en détectant le courant $I_2$ circulant dans le second conducteur (14) et engendrant un signal de sortie modifié ayant une amplitude proportionnelle à l'amplitude du courant $I_{in}$ fourni au diviseur coaxial de courant (10), et dans lequel la relation d'interaction entre les premier, second et troisième champs magnétiques se traduit, en outre, par une réduction de l'angle de phase entre $I_2$ et $I_{in}$, grâce à quoi le signal de sortie réduit est sensiblement en phase avec le courant $I_{in}$.

16

22 21 $I_{OUT}$

18

$R_2$

17

$I_2$ 14

20

8

$I_1 + I_2$

32

24

A

15

19

25

10

$R_1$

$I_1$

12

$I_{IN}$ 13

30

*FIG.1*

35 $I_1 + I_2$ 28

50

32

8

45

9

$I_1$

10

39

$I_2$

56

$I_2$

$I_2$ 16

33

14

$I_2$

31

29

37

58

42

27

23

40

12

43

26

46

41

44

30

48

38

$I_{IN}$

*FIG.3*

FIG.2

FIG.4

FIG. 5

FIG. 6a

FIG. 6b

FIG. 6c

Fig. 7

Fig. 9b

Fig. 9a

Fig. 9c

25

*FIG. 8a*

*FIG. 8b*

*FIG. 8c*